(19) Europäisches Patentamt
European Patent Office
Office européen des brevets

(11) **EP 1 975 283 B1**

(12) **EUROPEAN PATENT SPECIFICATION**

(45) Date of publication and mention
of the grant of the patent:
**23.11.2016 Bulletin 2016/47**

(51) Int Cl.:
*C30B 33/02* (2006.01)   *C30B 29/06* (2006.01)
*H01L 21/322* (2006.01)   *C30B 15/04* (2006.01)
*C30B 15/20* (2006.01)

(21) Application number: **06842997.6**

(22) Date of filing: **21.12.2006**

(86) International application number:
**PCT/JP2006/325489**

(87) International publication number:
**WO 2007/083476 (26.07.2007 Gazette 2007/30)**

(54) **PROCESS FOR PRODUCING SILICON SINGLE CRYSTAL WAFER**

VERFAHREN ZUR HERSTELLUNG EINES SILICIUMEINKRISTALLWAFERS

PROCÉDÉ DE FABRICATION DE TRANCHE DE MONOCRISTAL DE SILICIUM

(84) Designated Contracting States:
**DE FR**

(30) Priority: **17.01.2006 JP 2006008209**

(43) Date of publication of application:
**01.10.2008 Bulletin 2008/40**

(73) Proprietor: **Shin-Etsu Handotai Co., Ltd.
Tokyo (JP)**

(72) Inventor: **EBARA, Koji
Annaka-shi, Gunma 3790196 (JP)**

(74) Representative: **Wibbelmann, Jobst et al
Wuesthoff & Wuesthoff
Patentanwälte PartG mbB
Schweigerstrasse 2
81541 München (DE)**

(56) References cited:
**EP-A1- 0 962 556      EP-A1- 1 170 405
EP-A1- 1 313 137       WO-A1-2005/053010
JP-A- 11 079 889       JP-A- 2000 053 497
JP-A- 2001 203 210     JP-A- 2001 240 496
JP-A- 2001 503 009     JP-A- 2002 043 318
JP-A- 2002 187 794     JP-A- 2004 250 263
JP-A- 2005 206 391     US-A1- 2002 081 440**

## Description

TECHNICAL FIELD

The present invention relates to a method for manufacturing a silicon single crystal wafer in which a DZ layer without generation of crystal defects is formed from a wafer front surface to a constant depth to be a device active region, and oxide precipitate to be a gettering site can be formed inside the wafer.

BACKGROUND ART

Generally, the silicon single crystal wafer to be a material for semiconductor devices can be manufactured in such a way that a silicon single crystal is grown by a Czochralski method (Czochralski Method: hereinafter, called CZ method) and the obtained silicon single crystal ingot is subjected to processes of slicing, polishing, or the like.

The silicon single crystal grown by the CZ method in this way may cause an oxidation-induced stacking fault called OSF which is generated in a ring shape while being subjected to thermal oxidation processing

(for example, at 1100 degrees C for 2 hours). It has become clear that a micro defect (hereinafter, called Grown-in defect), which is formed during the crystal growth and has harmful effects on device performance exists other than OSF.

Accordingly, there has been recently disclosed a single crystal manufacturing method for obtaining the wafer in which these types of defects are reduced as less as possible, in Japanese Unexamined Patent Publication (Kokai) No. H11-79889 and Japanese Patent Publication No. 3085146, for example.
The European Patent Application EP1170405A1 describes a method for producing silicon single crystal by the Czochralski method, wherein the N-region is enlarged by doping with nitrogen.

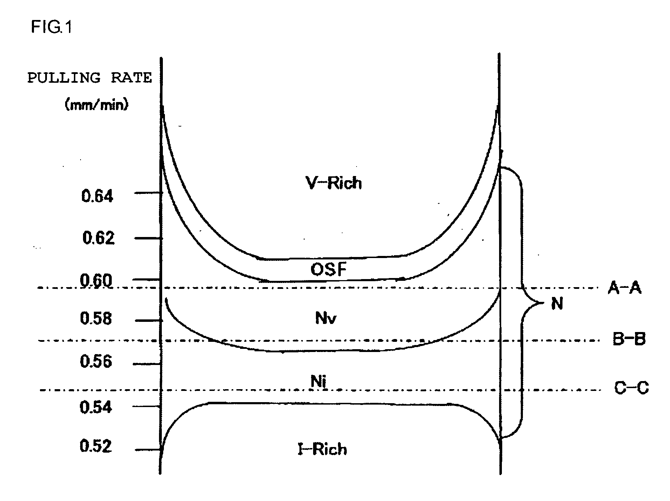

Fig. 1 shows one example of a relation between a pulling rate and a defect distribution when a single crystal is grown. It is a case where, by changing a pulling rate V (mm/min) during the single crystal growth, V/G which is a ratio between the pulling rate V and a mean value G (degree C /mm) which is a temperature gradient inside the crystal in a pulling axis direction in a temperature range from a silicon melting point to 1300 degrees C is changed.

It has generally known that a temperature distribution in the single crystal is dependent on a structure inside a CZ furnace (hereinafter, called hot zone) and thus the distribution will be hardly changed even when the pulling rate is changed. For this reason, V/G results will correspond to only the change in the pulling rate if the CZ furnaces with the same structure are used. Namely, there is approximately a direct proportion relation between the pulling rate V and V/G. Hence, the pulling rate V is used for a vertical axis shown in Fig. 1.

In a region where the pulling rate V is comparatively high, vacancy type Grown-in defects called COP (Crystal Originated Particle) or FPD (Flow Pattern Defect) that are voids where vacancies each of which is a point defect called a vacancy (Vacancy: hereinafter, called Va) are agglomerated exist in all the areas in a radial direction of a crystal, and it is called V-Rich region.

OSFs are generated in a ring shape from the periphery of the crystal when the pulling rate V becomes slightly slower than this, OSFs are shrunk toward the center thereof as the pulling rate V becomes slower, and OSFs are finally annihilated in the center of the crystal.

When the pulling rate V is further reduced, there exists Neutral (hereinafter, called N) region where excess and deficiency of Va and interstitial-type point defects called Interstitial Silicon (hereinafter, called I) are small. It has become clear that since in this N region concentrations of Va and I are not more than saturated concentrations although there may be deviations of Va or I, agglomerated defects such as aforementioned COP or FPD do not exist, or existence of the defects cannot be detected by a current defect detection method.

N region is classified into Nv region where Va is dominant and Ni region where I is dominant.

When the pulling rate V is still further reduced, I becomes supersaturated, so that defects of L/D (Large Dislocation: abbreviation of interstitial dislocation loop, for example LSEPD, LEPD, or the like) considered to be a dislocation loop where I are agglomerated are generated in lower density; and this region is called I-Rich region.

As a result of these described above, the slicing wafer from the single crystal which is pulled while controlling V/G in such a range that an entire area from the center of the crystal across the radial direction may become N region and polishing it makes it possible to obtain the wafer with extremely few defects, in which the entire plane in the radial direction becomes N region.

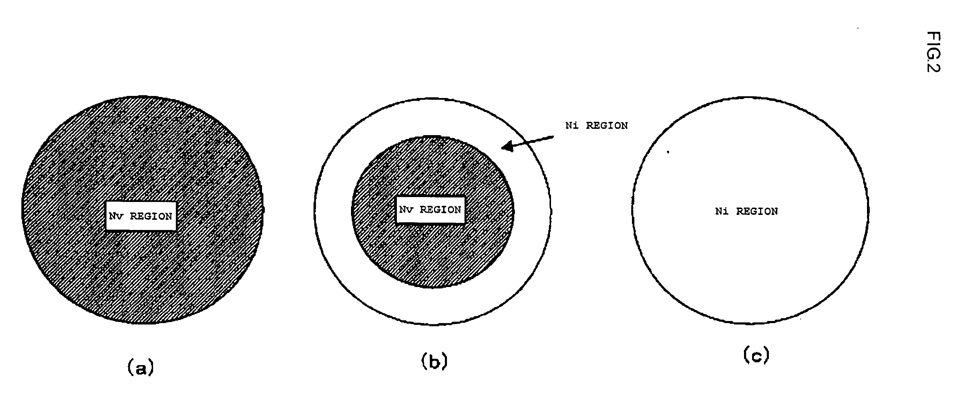

As an example, a wafer sliced from a position of A-A in Fig. 1 becomes a wafer whose whole area is Nv region, as shown in Fig. 2 (a). Fig. 2(b) shows a wafer sliced from a position of B-B in Fig. 1, in which there is Nv region in the wafer center and there is Ni region in an outer peripheral portion thereof.

Fig. 2 (c) shows a wafer sliced from C-C in Fig. 1, and it is possible to obtain a wafer in which the entire plane of the wafer is Ni region.

When the Grown-in defect which exists in V-Rich region or I-Rich region appears in the wafer front surface, it has harmful effects on device properties, such as degradation of an oxide dielectric breakdown voltage or the like in forming a MOS (Metal Oxide Semiconductor) structure of the device, and thus it is desired that there is no such defects in the wafer front surface layer.

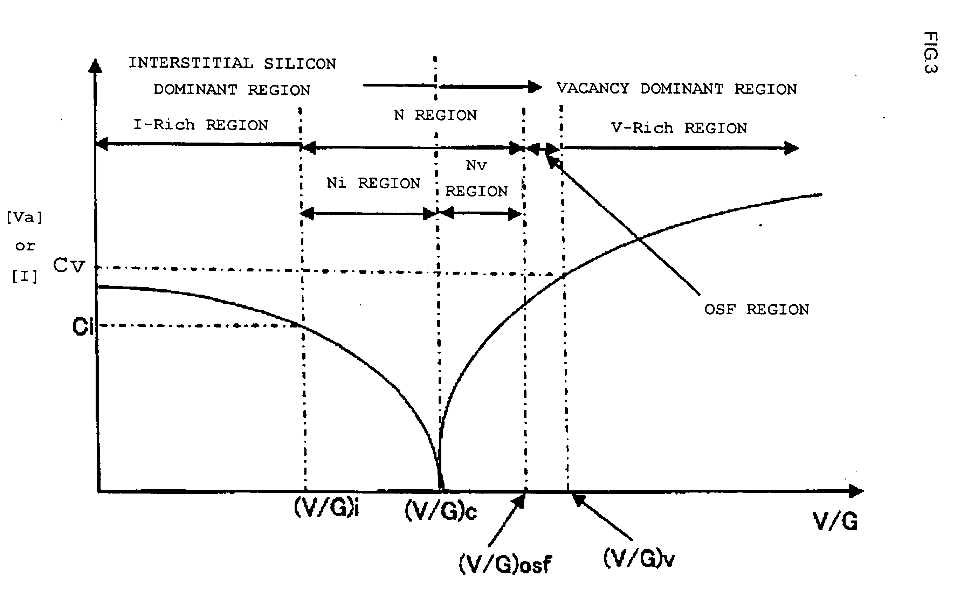

Fig. 3 schematically shows a relation between V/G, and a Va concentration and an I concentration, wherein this relation is called a Voronkov's theory, and it is shown that a boundary between a vacancy region and an interstitial silicon region is determined by V/G.

More specifically, a region where Va is dominant is formed when V/G is not less than a critical point (V/G) c, and a region where I is dominant is formed when it is not more than the critical point. Namely, (V/G) c indicates a V/G value where Va and I become the same concentration.

I-Rich region in Fig. 3 is a region where an agglomerate of interstitial-type silicon point defects, namely, the Grown-in defect of L/D is generated since V/G is not more than (V/G)i and the interstitial silicon-type point defect I is not less than the saturated concentration Ci.

V-Rich region is a region where an agglomerate of vacancies, namely, Grow-in defects, such as, COP or the like is generated since V/G is not less than (V/G)v and the vacancy Va which is the point defect is not less than the saturated concentration Cv.

N region indicates a neutral region ((V/G)i - (V/G)osf) where the agglomerate of the vacancies or the agglomerate of the interstitial-type silicon point defects does not exist.

OSF region ( (V/G) osf - (V/G)v) typically exists adjacent to this N region.

Incidentally, oxygen about 7 - 10x10$^{17}$ atoms/cm$^3$ (use the conversion factor based on JEIDA: Japan Electronic Industry Development Association) is typically included in the silicon wafer in a supersaturated state.

As a result, when such the silicon wafer is subjected to a heat treatment in a device processing or the like, supersaturated oxygen in the silicon wafer is precipitated as an oxide precipitate. Such an oxide precipitate is called BMD (Bulk Micro Defect).

While generation of this BMD in the device active region in the wafer causes problems since it has harmful effects on device properties, such as junction leakages or the like, it is effective to serve as a gettering site for capturing metal impurities mixed during the device processes as far as it exists in a bulk other than the device active region.

For that reason, in manufacturing the silicon wafer, BMD must be formed into the bulk of the wafer, and the vicinity of the wafer front surface, which is the device active region must maintain a defect-free region (Denuded Zone; hereinafter, called DZ layer) where neither BMD nor the Grown-in defect or the like exists.

In recent years, as a method for manufacturing the silicon wafer which is designed in such a way that BMD is not generated inside the wafer at the shipping stage of the silicon wafer, but BMD will be formed in the bulk deeper than the device active region by performing heat treatment of the subsequent device processes or the like to thereby provide gettering capability, while maintaining the DZ layer without BMD in the vicinity of the wafer front surface which is the device active region, a method of performing RTP (Rapid Thermal Process) processing on the silicon wafer (rapid thermal annealing) has been proposed (refer to, for example, Japanese Unexamined Patent Publication (Kokai) No. 2001-203210, USP No. 5401669 official report, and Patent Application Publication No. 2001-503009).

This RTP processing is a heat treatment method characterized in that in a nitridating atmosphere, such as $N_2$, $NH_3$, or the like, or a mixed gas atmosphere of these gases and a non-nitridating atmosphere, such as Ar, $H_2$, or the like, the silicon wafer is rapidly heated up from a room temperature at a heating rate of, for example, 50 degrees C/second, and after keeping heating it at a temperature of about 1200 degrees C for several tens of seconds, it is rapidly cooled down at a cooling rate of, for example, 50 degrees C/second.

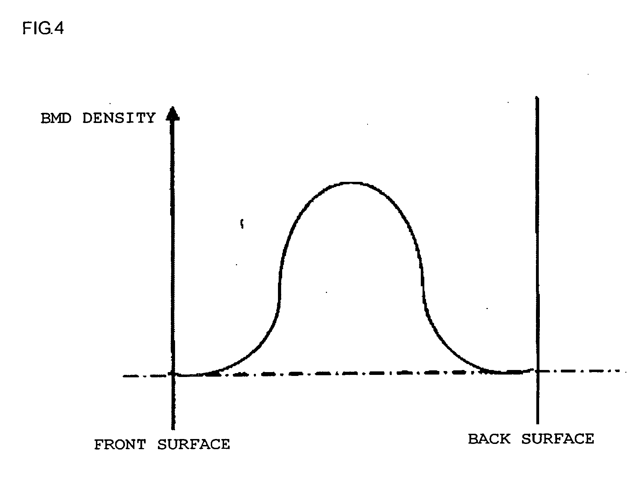

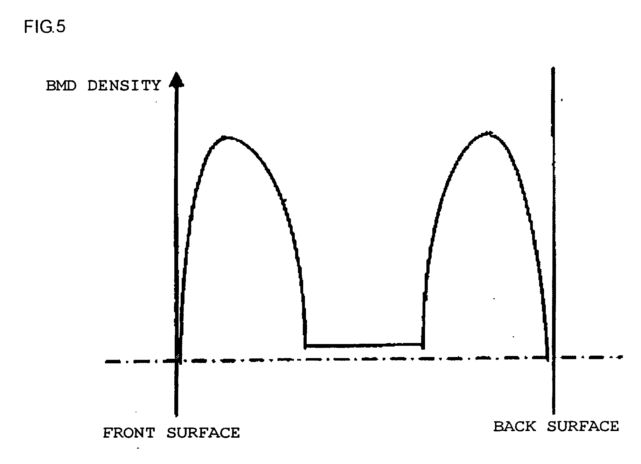

Such RTP processed silicon wafer can generate BMD by being subjected to heat treatment, such as a subsequent oxygen precipitation heat treatment or the like. It is known that a concentration distribution of this BMD in a depth direction will change with processing conditions in the RTP processing. As one example, schematic diagrams of the concentration distribution of BMD in the depth direction, which is formed after the oxygen precipitation heat treatment, with respect to the silicon wafer subjected to the heat treatment in an atmosphere of only an Ar gas and a silicon wafer subjected to the heat treatment in an atmosphere of an $N_2$/Ar mixed gas are shown in Fig. 4 and Fig. 5, respectively.

Here, mechanisms for BMD to be formed by performing the oxygen precipitation heat treatment after the RTP processing will be described briefly.

First, in the RTP processing, injection of Va occurs from the wafer surface during holding high temperature of, for example, 1200 degrees C in the $N_2$ atmosphere, and re-distribution by Va diffusion and annihilation by recombination with I occur while cooling down the wafer at a cooling rate of 50 degrees C/second in a temperature range of 1200 degrees C to 700 degrees C. As a result, it becomes a state where Va is unevenly distributed in the bulk.

By applying, for example, the oxygen precipitation heat treatment to the wafer in such a state, the oxide precipitates are clustered in the high Va concentration region and the clustered oxide precipitate grows to then form BMD. As described above, if the oxygen precipitation heat treatment is applied to the silicon wafer after the RTP processing, BMD, which has the distribution in the wafer depth direction will be formed according to a concentration profile of Va formed by the RTP processing.

Hence, a desired Va concentration profile is formed in the silicon wafer by controlling conditions, for example, the atmosphere, the highest temperature, the holding time or the like of the RTP processing, and the oxygen precipitation heat treatment is performed on the silicon wafer obtained thereafter, so that the silicon wafer which has desired DZ layer thickness and BMD profile in the depth direction can be manufactured.

Thus, it is effective since the desired DZ layer thickness and BMD profile can be obtained by newly injecting Va based on the RTP processing. However, when the Grown-in defects such as COP or L/D exist in the silicon wafer to be the material, these types of defects cannot sufficiently be annihilated because the heat treatment time is extremely short in the RTP processing.

As a result of this, it is possible to secure the region where BMD is not generated from the surface to a certain depth thereof when the RTP processing is performed on the silicon wafer having the Grown-in defects, but even when the Grown-in defects can be annihilated in a very shallow region of the surface by the RTP processing, it results in a state where the Grown-in defects exist in a region deeper than the very shallow region, and thus the whole device active region cannot be made defect-free. For this reason, there have been problems that device properties are degraded.

Accordingly, there is proposed a method in, for example, Japanese Unexamined Patent Publication (Kokai) No. 2001-203210, wherein the silicon wafer is sliced from the single crystal of N region without the agglomerates of Va or I, and the RTP processing is performed on the wafer whose whole area in the radial direction is N region. If the crystal whose whole area is N region is used, a desired wafer, which is defect-free in the wafer front surface layer but has BMD in the bulk after the RTP processing should be obtained. However, there have been cases where the device properties are degraded in the wafer after the RTP although the wafer whose whole area in the radial direction is N region is used as the material in this way.

DISCLOSURE OF THE INVENTION

The present invention is made in view of such problems, and aims at providing a manufacturing method capable of efficiently and certainly manufacturing the silicon single crystal wafer in which a DZ layer with sufficient thickness can be secured in a wafer front surface layer region and oxide precipitate which serves as a gettering site can also be formed in a bulk region of the wafer.

In order to solve the aforementioned problems, the present invention provides a method for manufacturing a silicon single crystal wafer in which a silicon single crystal ingot is pulled by a Czochralski method and a wafer sliced from the silicon single crystal ingot is subjected to a rapid thermal annealing, wherein wafers sliced from the silicon single crystal ingot which has been pulled while changing a pulling rate are subjected to rapid thermal annealings in various heat treatment temperatures, oxide dielectric breakdown voltage measurements are performed after the rapid thermal annealings to get a relation between the pulling rate and the heat treatment temperatures, and a result of the oxide dielectric breakdown voltage measurements in advance, conditions of a pulling rate when the silicon single crystal ingot is grown and a heat treatment temperature in the rapid thermal annealing are determined based on the relation so that a whole area thereof in a radial direction may become N region after the rapid thermal annealing, and the pulling of the silicon single crystal ingot and the rapid thermal annealing are performed to thereby manufacture the silicon single crystal wafer.

As described above, as preliminary tests, the rapid thermal annealings are first subjected in various heat treatment temperatures, to the wafers sliced from the silicon single crystal ingot which has been pulled by the Czochralski method while changing the pulling rate, and the oxide dielectric breakdown voltage measurements are performed thereafter to get the relation between the pulling rate and the heat treatment temperatures, and the result of the oxide dielectric breakdown voltage measurements. And conditions of a pulling rate when a silicon single crystal ingot is grown and a heat treatment temperature in a rapid thermal annealing are then determined based on the relation so that a whole area thereof in a radial direction may become N region after the rapid thermal annealing, and the pulling of the silicon single crystal ingot and the rapid thermal annealing are performed to thereby manufacture a silicon single crystal wafer. And thereby, even when Nv region exists in the wafer sliced from the ingot, it can be prevented that a total sum with vacancies newly injected by the rapid thermal annealing becomes a saturated concentration or more and that the vacancies agglomerate to thereby form vacancy-type Grown-in defects. As a result, a range sliced from the ingot can be expanded as a material, and thus allowing yield and productivity to be improved. In addition, the DZ layer is secured in the surface layer of the wafer to thereby allow the device properties such as oxide dielectric breakdown voltage characteristics or the like to be prevented from degradation, and it is also possible to efficiently and certainly manufacture high quality wafer in which BMD can be sufficiently formed in the bulk region by the oxygen precipitation heat treatment.

At this time, it is preferable that the silicon single crystal ingot is pulled at such a pulling rate that the whole area in the radial direction is Ni region.

As described above, if the silicon single crystal ingot is pulled at such a pulling rate that the whole area thereof in the radial direction becomes Ni region, the whole area in the radial direction of the wafer before the rapid thermal annealing which has been sliced from the ingot will be Ni region. And since it is extremely hard to generate agglomeration of the vacancies even when the heat treatment temperature in the rapid thermal annealing is high at this time and the vacancies are injected, and thus it is possible to simply set the conditions of the rapid thermal annealing, allowing the high quality silicon single crystal wafer to be efficiently manufactured.

Moreover, it is preferable the silicon single crystal ingot is doped with nitrogen in a concentration of $1\times10^{11}$ - $1\times10^{15}$ atoms/cm$^3$ and/or carbon in a concentration of $1\times10^{16}$ - $1\times10^{17}$ atoms/cm$^3$ during pulling the silicon single crystal ingot.

As described above, by doping the silicon single crystal ingot with nitrogen in the concentration of $1\times10^{11}$

atoms/cm$^3$ or more, an increase in N region when pulling the silicon single crystal ingot and a facilitatory effect of oxygen precipitation can be made remarkable. In addition, by setting the concentration to 1x10$^{15}$ atoms/cm$^3$ or less, an increase in cost of the crystal manufacturing can be prevented without preventing single crystalization of silicon.

Moreover, by doping the silicon single crystal ingot with carbon in the concentration of 1x10$^{16}$ or more, oxygen precipitation can be effectively promoted, and the carbon itself can be used as a gettering site. If the concentration is set to 1x10$^{17}$ atoms/cm$^3$ or less at this time, it is possible to prevent degradation of the lifetime of the wafer due to carbon.

Further, it is preferable that the silicon single crystal ingot is doped with oxygen in a concentration of not less than 8 ppm and not more than 15 ppm during pulling the silicon single crystal ingot.

As described above, if the silicon single crystal is doped with oxygen in the concentration of not less than 8 ppm during pulling the silicon single crystal ingot, the DZ layer with a sufficient thickness is formed in the surface layer region of the wafer where the vacancy concentration is relatively low, by the oxygen precipitation heat treatment after the rapid thermal annealing, and it is also possible to effectively form the oxide precipitate in the bulk region of the wafer with a high vacancy concentration. Moreover, if the concentration is set to 15 ppm or less, it is also possible to sufficiently secure the DZ layer in the surface layer region of the wafer, and a strong gettering effect is provided due to sufficient precipitate formation in bulk portion, and the precipitate is not formed more than needs, either. For this reason, it is possible to manufacture the high quality wafer provided with the gettering capability, in which device properties are not degraded.

It is then preferable that the rapid thermal annealing is performed under a non-oxidizing atmosphere.

In the method for manufacturing the silicon wafer of the present invention, it is preferable to perform the rapid thermal annealing under the non-oxidizing atmosphere as described above, and for example, N$_2$, NH$_3$, NO, N$_2$O, N$_2$O$_2$, or the like is used as an atmosphere gas, and it can be set as a nitridating atmosphere. Moreover, for example, H$_2$, Ar, He, or the like is used, and it can also be set as a non-nitridating atmosphere. It can also be performed under a mixed atmosphere of these nitridating atmosphere and non-nitridating atmosphere.

Moreover, it is preferable that the heat treatment temperature is set to not less than 1100 degrees C and not more than 1300 degrees C in the rapid thermal annealing.

If the heat treatment temperature is set to not less than 1100 degrees C in the rapid thermal annealing as described above, it is possible to manufacture the silicon single crystal wafer in which the oxide precipitate can be sufficiently obtained. It is then easy to uniformly heat the inside of the wafer surface by setting the heat treatment temperature to not more than 1300 degrees C, and generation of slip due to thermal stress hardly occurs. It is also hard to generate metal contamination.

Given the method for manufacturing the silicon single crystal wafer of the present invention as described above, the range, which can be sliced from the ingot can be expanded, and thus allowing yield and productivity to be improved. It is then possible to efficiently and certainly manufacture the high quality wafer in which the sufficient DZ layer is secured in the surface layer after the oxygen precipitation heat treatment, and further, the oxide precipitate can sufficiently be formed in the bulk region.

BRIEF DESCRIPTION OF THE DRAWINGS

Fig. 1 is a schematic illustration showing one example of a relation between a pulling rate and a defect distribution when a silicon single crystal ingot is grown;

Fig. 2 is a schematic diagram showing a radial distribution of defect of a wafer radially sliced from the silicon single crystal ingot;

Fig. 3 is a schematic illustration showing a relation between V/G, and a Va concentration and an I concentration;

Fig. 4 is a schematic diagram showing one example of a concentration distribution of BMD formed after an oxygen precipitation heat treatment in a depth direction (RTP atmosphere: Ar gas only);

Fig. 5 is a schematic diagram showing another examples of a concentration distribution of BMD formed after the oxygen precipitation heat treatment in a depth direction (RTP atmosphere: N$_2$/Ar mixed gas);

Fig. 6 is a schematic illustration showing a relation between V/G, and the Va concentration and the I concentration before and after RTP processing;

Fig. 7 is graph showing a relation between a vacancy concentration and BMD after a precipitation heat treatment;

Fig. 8 is a view showing a relation between a heat treatment temperature of a rapid thermal annealing, a pulling rate, and an oxide dielectric breakdown voltage; and

Fig. 9 is a schematic diagram of a radial distribution of defects, which shows a result of oxide dielectric breakdown voltage measurements in a comparative example.

BEST MODE(S) FOR CARRYING OUT THE INVENTION

Hereinafter, embodiments of the present invention will be described, but the present invention is not limited thereto.

As a manufacturing method of a wafer which has a DZ layer in a surface layer region and BMD in a bulk region capable of having gettering capability, there is conventionally a method of performing the RTP processing on the wafer, which are sliced from N region of the single crystal ingot where the agglomerate of Va or I does not exist, and whose whole area in the radial direction is N region, for example. However, even when the silicon wafer of N region which does not include the Grown-in defects thereinside is prepared as a material in this way, there has been a problem that an oxide dielectric breakdown voltage is degraded when the oxide dielectric breakdown voltage is measured after the RTP processing.

As a result of earnest researches on the RTP processing of the wafer, the present inventor has found that the aforementioned degradation of the oxide dielectric breakdown voltage after the RTP processing is easily caused when a silicon single crystal wafer including Nv region is used as the material. After further investigations, the present inventor has found that, even in Nv region, the aforementioned degradation of the oxide dielectric breakdown voltage is remarkably generated in a portion near OSF region, namely in a region where Va concentration is relatively high although agglomeration of Va is not generated, and accomplished the present invention.

Hereinafter, the present invention is specifically described with reference to the drawings.

First, causes that the oxide dielectric breakdown voltage is degraded after the rapid thermal annealing in spite of using the silicon wafer whose whole area in the radial direction is N region will be described. Although this cause has not been clear, the inventor has considered that the aforementioned degradation of the oxide dielectric breakdown voltage is caused by a mechanism, which will be described hereinafter.

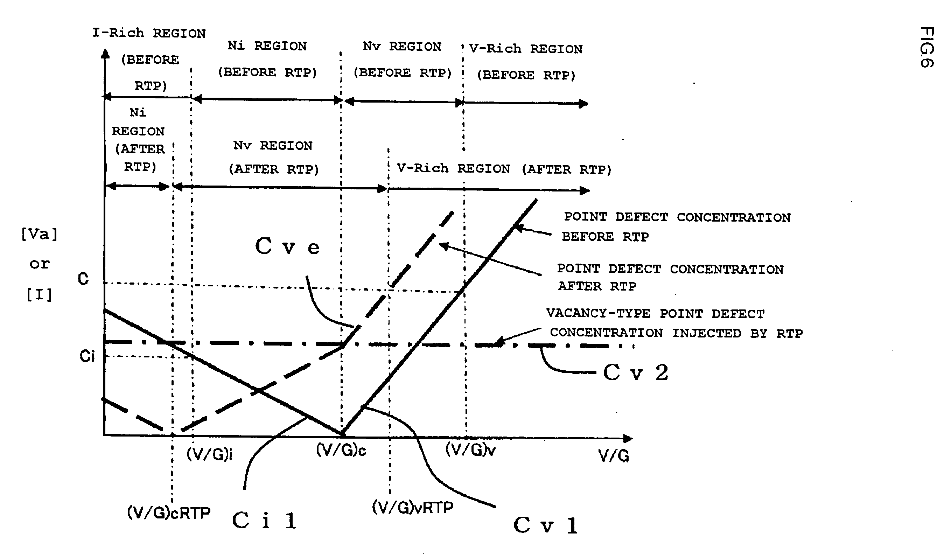

Fig. 6 is for describing the aforementioned mechanism, which is a schematic illustration showing a change of defect regions in the wafer before and after the RTP processing. Incidentally, since OSF region is basically irrelevant in the description of this mechanism, OSF region is not described therein for simplification.

In a state before the rapid thermal annealing, let the vacancy concentration of the silicon wafer be Cv1 and the interstitial silicon-type point defect concentration be Ci1, and respective saturated concentrations be Cv and Ci, respectively, as shown in Fig. 6, values of V/G at intersections between Cv1 and Cv and between Ci1 and Ci, namely, (V/G) v and (V/G) i become boundaries between V-Rich region and N region, and N region and I-Rich region, respectively. A boundary between Nv region and Ni region shall have a critical value (V/G)c.

Further, let (V/G)vRTP and (V/G)cRTP be borders between V-Rich region and N region, and Nv region and Ni region after RTP, respectively.

Here, assuming that the vacancy concentration injected by the RTP processing is Cv2, I and Va form a pair to be then annihilated after the RTP processing, and thus a net vacancy concentration Cve in the silicon wafer after the rapid thermal annealing is given as following Equation.

$$Cve = Cv1 - Ci1 + Cv2$$

Hence, the vacancy concentration after the RTP processing increases by Cv2 in Nv region (it can approximate Cil=0), and a vacancy concentration in Ni region (it can approximate Cv1=0) will be given by deducting I concentration Ci1, which originally existed from the vacancy concentration Cv2 injected by the RTP processing.

For this reason, it is considered that as for the wafer in a region where V/G is (V/G) vRTP or more among Nv region (Nv region (before RTP) ) in a state before RTP, since a net vacancy-type defect concentration becomes the saturated concentration Cv or more by the RTP processing, agglomeration of vacancy is generated to thereby form a vacancy-type defect, so that resulting in V-Rich region (V-Rich region (after RTP) ).

As a result of this, it can be understood that a reason why the above-mentioned degradation of the oxide dielectric breakdown voltage is remarkable after the RTP processing in the region near OSF region among Nv region (before RTP), namely, the region where the Va concentration is relatively high although the agglomeration of Va is not generated is because the concentration Cv1 of the vacancy which exists in the silicon wafer before the rapid thermal annealing is high in that region and a degree of supersaturation of the vacancy concentration before the rapid thermal annealing is high as compared with that of Nv region (before RTP) near Ni region (before RTP), and thus vacancies are injected by RTP and agglomeration of point defect is easily generated.

On the contrary, I of the concentration Ci1 originally exists in the regions, which have been I-Rich region (before RTP) and Ni region (before RTP) before the RTP processing. When Va with the concentration Cv2 is injected by the RTP processing in this state, I and Va will form a pair to be then annihilated, and excessive point defects will remain.

Higher density BMD will be generated in a case where the precipitation heat treatment is similarly performed after the RTP processing on the wafer as compared with a case where the precipitation heat treatment is performed on the wafer whose whole area is Ni region (before RTP) where vacancies hardly exist, and thus the wafer after the RTP processing is considered that the vacancy is dominant.

Assuming from this, since it is considered that the I concentration Ci1 in Ni region (before RTP) is lower than the Va concentration Cv2 injected by RTP, it is considered that a portion which has been Ni region (before RTP) before RTP becomes Nv region (after RTP) (namely, (V/G)cRTP - (V/G)vRTP) after RTP. Synthetically judging from the foregoing, it is considered that although the boundary between the vacancy region and the interstitial silicon region has been (V/G)c before RTP, it shifts to a position of (V/G)cRTP after the RTP processing.

Moreover, it is considered from Fig. 6 that, using (V/G) cRTP as a boundary value, the region which has been I-Rich region (before RTP) becomes Nv region (after RTP) in the case V/G is larger than that, and Ni region (after RTP) in the case V/G is smaller than that, after RTP.

However, this is a result simply judged by only a point that the net vacancy concentration and the net interstitial silicon concentration are not more than the saturated concentration, and, in practice, agglomeration of I already has generated at a stage of the wafer sliced from the ingot before the RTP processing and the defect has been formed in I-Rich region (before RTP) which is I-Rich region before RTP. Since this defect is hardly annihilated by the RTP processing as described above, it seems that it is still a defect generation region even after RTP.

Hence, the wafer which does not include I-Rich region (before RTP) is preferably used as the material to be subjected to RTP processing.

As described above, it has become clear that since the vacancies are injected by RTP to thereby shift the defect distribution, the Grown-in defects, such as COP or the like are caused after RTP to thereby degrade the breakdown voltage, in spite of performing RTP on the whole area N region crystal. Hence, in order to certainly obtain the silicon wafer whose whole area is the truly N region after RTP, it is necessary to manufacture the wafer while taking into consideration of this shift due to RTP.

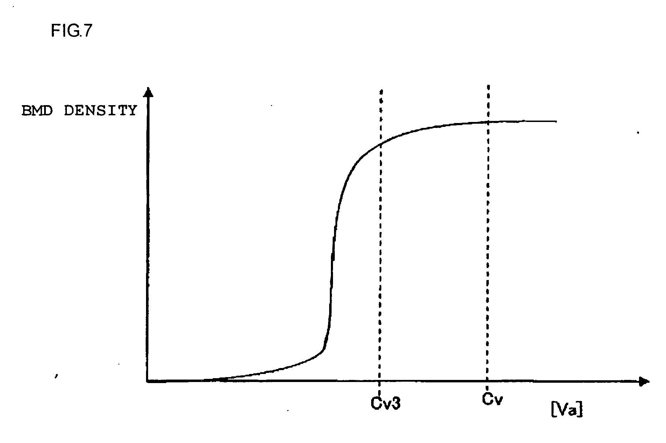

Incidentally, with reference to Fig. 7, the relation between the vacancy concentration and BMD after the precipitation heat treatment will be described here.

Although the density of BMD which is generated when a oxygen precipitation heat treatment is applied after the RTP processing generally increases with an increase in the concentration of Va, it is considered that BMD is saturated at a certain value (for example, Cv3) or more.

Meanwhile, the saturated concentration Cv of Va is generally considered higher than Cv3. This makes it possible that there is no generation of the vacancy type defect and that BMD having a gettering function in the bulk region is formed by controlling the net vacancy concentration (Cve) after the RTP processing given by the above-described equation to the vacancy concentration (Cv3 or more), which is sufficiently high to such an extent that an oxide precipitate cluster to be a core of BMD formation is formed although sufficiently low (Cv or less) to such an extent that the agglomeration of vacancy is not generated.

In consideration of the mechanisms described above, as the method for manufacturing the silicon single crystal wafer, the relation between the pulling rate of the silicon single crystal ingot and the heat treatment temperature in the rapid thermal annealing, and the result of the oxide dielectric breakdown voltage measurements is gotten by performing following preliminary tests in the present invention. Note herein that the manufacturing method of the present invention can be performed using the pulling apparatus and the rapid thermal annealing apparatus similar to the conventional ones.

First, the silicon single crystal ingot is pulled by the Czochralski method while changing the pulling rate. V/G is controlled and changed by changing the speed for pull-up in this way, so that the silicon single crystal ingot having various defect regions can be obtained.

Subsequently, the wafers are sliced from such an ingot to be then used as sample wafers for preliminary tests. As a matter of course, these sample wafers result in wafers having various defect regions.

Incidentally, when pulling the silicon single crystal ingot, the silicon single crystal ingot may be preferably doped with nitrogen in a concentration of $1 \times 10^{11}$ - $1 \times 10^{15}$ atoms/cm$^3$. If the silicon single crystal is doped with nitrogen within such a concentration range, expansion of N region during pulling of the ingot and facilitatory effects of oxygen precipitation can be made remarkable without preventing single crystallization of silicon.

Alternatively, the silicon single crystal ingot may be preferably doped with carbon in a concentration of $1 \times 10^{16}$ - $1 \times 10^{17}$ atoms/cm$^3$. Precipitation of oxygen can be effectively promoted and carbon itself can be used as a gettering site by doping with carbon in such a concentration range without causing degradation of the lifetime of the wafer.

Further, if the oxygen concentration of the wafer sliced from the silicon single crystal ingot shall be not less than 8 ppm and not more than 15 ppm, the DZ layer can be secured in the surface layer region of the wafer with sufficient thickness, and also the oxide precipitate can be effectively formed in the bulk region after the oxygen precipitation heat treatment. For that reason, it is possible to obtain the high quality wafer sufficiently provided with gettering capability, without degrading device properties, such as oxide dielectric breakdown voltage or the like.

Next, such sample wafers are subjected to the rapid thermal annealing in various heat treatment temperatures.

The atmosphere during the rapid thermal annealing at this time is preferably a non-oxidizing atmosphere, and it may be a nitridating atmosphere by using, for example, $N_2$, $NH_3$, $NO$, $N_2O$, $N_2O_2$, or the like.

Alternatively, $H_2$, Ar, He, or the like may be used, and an atmosphere in which these are mixed may be used, and thus it will not be particularly limited as far as the non-oxidizing atmosphere is used.

Further, it is preferable to set this heat treatment temperature in the rapid thermal annealing to not less than 1100 degrees C and not more than 1300 degrees C., for example. By setting it to not less than 1100 degrees C, the oxide precipitate can sufficiently be formed particularly in the bulk region of the wafer during the subsequent oxygen precipitation heat treatment. Meanwhile, by setting it to not more than 1300 degrees C, the wafer can be uniformly heated across the surface thereof, and thus allowing slip generation due to thermal stress to be effectively prevented. In addition, if it is within such a temperature range, metal contamination to the wafer can be suppressed.

The sample wafers, which have been subjected to different heat treatment conditions can be obtained by performing the aforementioned rapid thermal annealings in various heat treatment temperatures.

After this rapid thermal annealing processes, each of the obtained sample wafers is measured with respect to the oxide dielectric breakdown voltage. The relation between the obtained result of the oxide dielectric breakdown voltage measurements, and the pulling rate of the ingot and the heat treatment temperatures in the rapid thermal annealings is then gotten. For example, a certain fixed criterion is provided in a pass rate of a C mode which is an intrinsic failure mode of the oxide film, and the relation may be gotten so that conditions of the pulling rate and the heat treatment temperature in the case of the sample wafer which have reached the criterion, and conditions thereof in the case of the sample wafer which have not reached the criterion, conversely, may be discriminated with each other. This way may be such that the relation of the aforementioned pulling rate, heat treatment temperatures, and result of the oxide dielectric breakdown voltage measurements is understood according to the object, and its form or the like is not limited.

Conditions of the pulling rate and the heat treatment temperature are determined based on the relation gotten in this way so that the whole area in the radial direction may become N region after the rapid thermal annealing, and further, a silicon single crystal ingot is newly pulled according to the conditions of the pulling rate and the heat treatment temperature and a wafer sliced from the ingot is subjected to the rapid thermal annealing to thereby manufacture a silicon single crystal wafer.

With the above manufacturing method, even when the vacancies are injected by RTP to thereby shift the defect distribution, it is possible to manufacture the silicon wafer whose whole area in the radial direction certainly becomes N region after the rapid thermal annealing. For example, even when Nv region in which a total sum of the vacancies which originally exist in the wafer and the vacancies newly injected by the rapid thermal annealing may become the saturated concentration or more exists in the wafer sliced from the ingot, the heat treatment temperature which does not make the total be the saturated concentration or more and which can make the whole area stay in N region (namely, which can make the whole area be Nv region (after RTP) instead of V-rich region (after RTP) in Fig. 6) can be gotten and determined from the aforementioned relation to manufacture the wafer. As described above, even when the wafer before the rapid thermal annealing is a wafer of Nv region, it can prevent beforehand the vacancies from agglomerating and becoming the vacancy-type Grown-in defect, and thus allowing the wafer of Nv region to be used as the material. As a result of this, the range which can be sliced from the ingot to be used as the material can be expanded, and degradation of the device properties such as oxide dielectric breakdown voltage characteristics can also be certainly suppressed, and thus allowing yield and productivity to be improved, and the high quality silicon single crystal wafer to be efficiently manufactured. Further, it is possible to manufacture the good silicon single crystal wafer in which the DZ layer can be formed in the surface layer region and BMD can sufficiently be formed in the bulk region when the oxygen precipitation heat treatment is applied.

Particularly, when pulling the ingot, it may be pulled at the pulling rate so that the whole area in the radial direction may be Ni region. At this time, as for the silicon wafer sliced from the ingot, the whole area thereof becomes Ni region, the vacancies before the rapid thermal annealing do not exist (namely, it can be regarded as Cv1=0), and only the interstitial silicon-type point defects exist, and thus the vacancy concentration Cve after the rapid thermal annealing is given by the following equation, since Cv1=0.

$$Cve = Cv2 - Cil$$

As a result of repeating the experiments and investigating it in detail, the present inventor has found that Cve does not become supersaturated in this case even when the retention temperature of the rapid thermal annealing is set to, for example, 1270 degrees C.

Hence, when the wafer whose whole area in the radial direction is Ni region is used as the material, what is necessary is just to set the conditions in the rapid thermal annealing so that a desired BMD may be obtained, and thus allowing the high quality silicon wafer to be obtained extremely efficiently and simply.

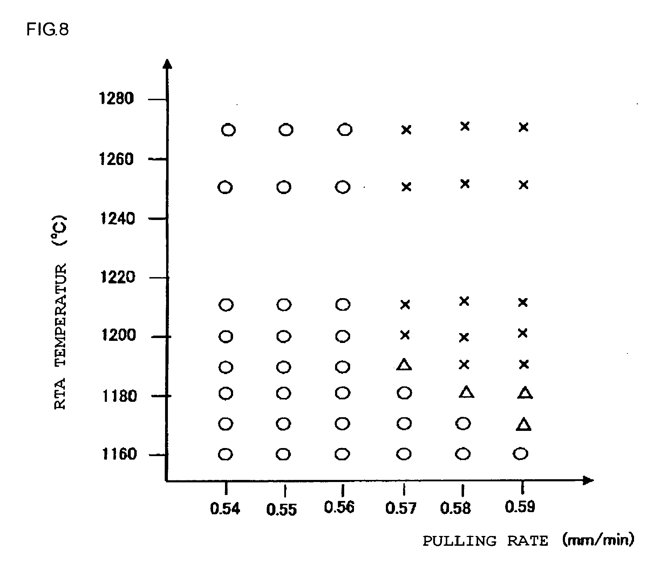

Thus, in the present invention, one example of getting the relation between the heat treatment temperatures (the highest retention temperatures) of the rapid thermal annealings, the pulling rate, and the oxide dielectric breakdown voltage is shown in Fig. 8. The relation between the pulling rate and the defect distribution is the same as that shown in Fig. 1.

In Fig. 8, regarding the pass rate in the C mode, which is the intrinsic failure mode of the oxide film, more than 96% is indicated by o, the pass rate which is 96% or less and more than 93% is indicated by Δ, and the pass rate which is 93% or less is indicated by ×.

As is apparent from Fig. 8, when the pulling rate is 0.56 mm/min or less, namely, when it is a wafer whose whole area in the radial direction is Ni region, reliability of the oxide films in all the wafers is excellent regardless of the heat treatment temperature of the rapid thermal annealing.

It turns out that when the pulling rate is not less than 0.57 and not more than 0.59 mm/min, namely, when Nv region exists in the wafer, although the whole area of the wafer is N region, the reliability of the oxide film begins to be degraded at lower temperature of the retention temperature of the rapid thermal annealing, as the pulling rate becomes higher.

This is because a regions near OSF region in Nv region as the pulling rate is higher as described above, and the concentration of the vacancies which exist in the silicon wafer before the rapid thermal annealing is higher in this region, the degree of supersaturation of the net vacancy concentration after the rapid thermal annealing is high as compared with a portion of Nv region near Ni region, and the point defects agglomerate to then become a defect easily. Moreover, it can be understood that since the higher the highest temperature of the rapid thermal annealing is, the higher the vacancy concentration to be injected becomes, the agglomeration of point defects is generated more easily because of the similar reason.

If the relation between the aforementioned three conditions shown in this Fig. 8 is gotten in advance, and the pulling rate and the heat treatment temperature are determined based on the relation so that the whole area in the radial direction may become N region after the rapid thermal annealing to thereby manufacture the silicon single crystal wafer, as described above, a desired silicon wafer can be certainly obtained. Specifically, the ingot was pulled on the condition which brings a result of o in Fig. 8, and the wafers sliced therefrom were subjected to the rapid thermal annealings on the conditions which bring the result of o. As a result of this, when the each of the wafers was subjected to the measurement with respect to the oxide dielectric breakdown voltage, the aforementioned pass rate was higher than 96% in all the wafers, the result of o could be obtained.

Subsequently, when these wafers after the rapid thermal annealings were further subjected to the oxygen precipitation heat treatments, excellent wafers, which had the DZ layer in the surface layer region and BMD formed in the bulk region and were sufficiently provided with gettering capability, could be obtained.

If the aforementioned preliminary tests are performed first, the relation between the pulling rate and the heat treatment temperatures, and the measurement result of the oxide dielectric breakdown voltage is gotten, and the wafer is manufactured based on the relation like the method for manufacturing the silicon single crystal wafer of the present invention as described above, the high quality silicon single crystal wafer in which the oxide dielectric breakdown voltage characteristics are not degraded can be efficiently manufactured with high yield even after the rapid thermal annealing is performed.

An excellent oxide precipitate profile is then formed inside this wafer by the aforementioned rapid thermal annealing, and the DZ layer is maintained in the wafer surface layer region and BMD is also formed in the bulk region by the oxygen precipitation heat treatment or the heat treatment in subsequent device processes, it is possible to manufacture the wafer with high gettering capability.

Hereinafter, while the present invention will be described in more detail by an Example and a Comparative example, the present invention is not limited thereto.

(Comparative example)

Using the single crystal pulling apparatus similar to the one conventionally used, the silicon single crystal ingot was grown by setting the pulling rate at 0.57 mm/min while controlling so that a diameter thereof might be 210 mm. And a wafer was radially sliced from the ingot, and the wafer processing was performed.

Incidentally, the ingot was doped with nitrogen in a concentration of $1 \times 10^{11}$ atoms/cm$^3$ during ingot pulling. In addition, an oxygen concentration of the cut-out wafer was 12 ppm (JEIDA). This wafer was rapidly heated from room temperature at a heating rate of 50 degrees C/second under a mixed atmosphere of NH$_3$ with flow rate 0.5 l/min and Ar with flow rate 4 l/min, using a commercial rapid thermal annealing apparatus (AST-2800 by Steag), and after holding it for 10 seconds at 1200 degrees C, it was rapidly cooled down at a cooling rate of 50 degrees C/second. Thereafter, a gate oxide film with 25 nm thick was formed on the wafer front surface, and then, the oxide dielectric breakdown voltage was measured.

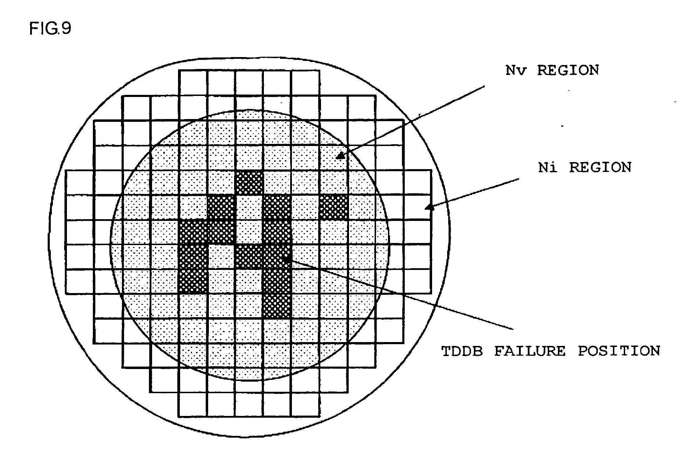

The result of the oxide dielectric breakdown voltage measurements of a comparative example is shown in Fig. 9. As shown in Fig. 9, the oxide dielectric breakdown voltage is degraded in the central portion of the wafer. Nv region and Ni region mixedly exist in this wafer, wherein Nv region is a range from the wafer center to within a concentric circle with a radius of 70 mm, and the outside thereof is Ni region. The degradation of the oxide dielectric breakdown voltage is generated in a range about 30 - 40 mm from the wafer center as can be seen from Fig. 9, and it turns out that the degradation is generated only in the central portion of Nv region instead of the whole Nv region.

This wafer is the wafer radially sliced from the silicon single crystal ingot, and the pulling rate V of the ingot is the same within the in-plane of the wafer. However, the mean value G (degree C/mm) of the temperature gradient inside the crystal in the pulling axis direction in the temperature range from a silicon melting point to 1300 degrees C is small in the center of the ingot, and becoming larger toward periphery. For this reason, V/G is getting larger in the wafer center even when the pulling rate is the same, and as a region is closer to the wafer center, it becomes a region near OSF region even in the same Nv region. As described above, the central region of Nv region in the wafer of the comparative example is a portion near OSF region at the phase of the ingot although the agglomeration of Va does is not generated, so that the vacancy concentration which exists in the silicon wafer before the rapid thermal annealing is high, and the degree of supersaturation of the net vacancy concentration after the rapid thermal annealing is high as compared with Nv region near Ni region (namely, near the outer circumference of Nv region of the wafer), thus the vacancy is easily agglomerated, and the defects are easily caused. Namely, it means that a region with the degraded breakdown voltage generated in the wafer center, in spite of performing the RTP processing using the wafer whose whole area is N region.

(Example)

Next, following preliminary tests were performed using the single crystal pulling apparatus similar to that used in the comparative example. The silicon single crystal ingot was grown by successively reducing the pulling rate from 0.7 mm/min to 0.5 mm/min, while controlling so that a diameter thereof may become 210 mm. The defect distribution in the cross section parallel to the pulling axis in this case is shown in Fig. 1. Subsequently, the wafer was radially sliced from this ingot and wafer processing was performed.

Wafers having a typical defect generation region among the cut-out wafers are shown below. In this single crystal ingot, a wafer sliced from the position of A-A in Fig. 1 became a wafer whose whole area was Nv region (hereinafter, called Nv wafer), as shown in Fig. 2 (a). In addition, Fig. 2 (b) shows a wafer sliced from the position of B-B in Fig. 1, resulting in a wafer in which there is Nv region in the wafer center, and the outer peripheral portion of the wafer around Nv region is Ni region (hereinafter, called NvNi mixed wafer). Moreover, Fig. 2 (c) shows a wafer sliced from C-C in Fig. 1, and there is obtained a wafer in which the whole area of the wafer is Ni region (hereinafter, called Ni wafer).

Incidentally, the ingot was doped with nitrogen in a concentration of $1\times10^{11}$ atoms/cm$^3$ during ingot pulling in a manner similar to that of the comparative example. In addition, an oxygen concentration of the cut-out wafer was 12 ppm (JEIDA).

These wafers sliced from the A-A, B-B, and C-C were rapidly heated from room temperature at a heating rate of 50 degrees C/second under a mixed atmosphere of NH$_3$ with flow rate 0.51/min and Ar with flow rate 41/min, using the rapid thermal annealing apparatus similar to that in the comparative example. And the highest temperatures are determined as 1150 degrees C, 1170 degrees C, and 1200 degrees C to the wafer sliced from A-A, B-B, and C-C, respectively, from the relation between the heat treatment temperature of the rapid thermal annealing and the pulling rate, and the oxide dielectric breakdown voltage which were gotten in advance, so that they may be N region even after the RTP processing, and after holding them for 10 seconds at these temperatures respectively, they were rapidly cooled down at a cooling rate of 50 degrees C/second. Thereafter, a gate oxide film with 25 nm thick was formed on each of the wafer front surfaces, and then, the oxide dielectric breakdown voltage was measured. As a result of this, the measurement results of the oxide dielectric breakdown voltage of all the wafers were o including the wafer sliced from A-A in which the whole area is Nv.

Incidentally, the present invention is not limited to the aforementioned embodiments. The aforementioned embodiments are only exemplifications, and what has substantially the same configuration and exerts substantially the same effect as what is described in the claims of the invention belongs to the technical scope of the invention.

## Claims

1.   A method for manufacturing a silicon single crystal wafer in which a silicon single crystal ingot is pulled by a Czochralski method and a wafer sliced from the silicon single crystal ingot is subjected to a rapid thermal annealing, wherein wafers sliced from the silicon single crystal ingot which has been pulled while changing a pulling rate are subjected to rapid thermal annealings in various heat treatment temperatures, oxide dielectric breakdown voltage measurements are performed after the rapid thermal annealings to get a relation between the pulling rate and the heat treatment temperatures, and a result of the oxide dielectric breakdown voltage measurements in advance, conditions of a pulling rate when the silicon single crystal ingot is grown and a heat treatment temperature in the rapid thermal annealing are determined based on the relation so that a whole area thereof in a radial direction may become N region which exists adjacent to OSF region after the rapid thermal annealing, and the pulling of the silicon single crystal ingot and the rapid thermal annealing are performed to thereby manufacture the silicon single crystal wafer.

2.   The method for manufacturing the silicon single crystal wafer according to claim 1, wherein the silicon single crystal ingot is pulled at such a pulling rate that the whole area in the radial direction is Ni region.

3.   The method for manufacturing the silicon single crystal wafer according to claim 1 or claim 2, wherein the silicon single crystal is doped with nitrogen in a concentration of $1\times10^{11}$ - $1\times10^{15}$ atoms/cm$^3$ and/or carbon in a concentration of $1\times10^{16}$ - $1\times10^{17}$ atoms/cm$^3$ during pulling the silicon single crystal ingot.

4.   The method for manufacturing the silicon single crystal wafer according to any one of claim 1 to claim 3, wherein the silicon single crystal is doped with oxygen in a concentration of not less than 8 ppm and not more than 15 ppm during pulling the silicon single crystal ingot.

5. The method for manufacturing the silicon single crystal wafer according to any one of claim 1 to claim 4, wherein the rapid thermal annealing is performed under a non-oxidizing atmosphere.

6. The method for manufacturing the silicon single crystal wafer according to any one of claim 1 to claim 5, wherein in the rapid thermal annealing, the heat treatment temperature is set to not less than 1100 °C and not more than 1300 °C.

**Patentansprüche**

1. Verfahren für die Herstellung eines Silizium-Einkristall-Wafers, in dem ein Silizium-Einkristall-Ingot durch ein Czochralski-Verfahren gezogen wird und ein von dem Silizium-Einkristall-Ingot geschnittener Wafer einer schnellen thermischen Behandlung (rapid thermal annealing) unterzogen wird, wobei Wafer, die von dem Silizium-Einkristall-Ingot abgeschnitten wurde, der gezogen wurde, während eine Ziehgeschwindigkeit geändert wurden, schnellen thermischen Behandlungen bei verschiedenen Wärmebehandlungs-Temperaturen unterzogen werden, Oxiddielektrische Durchschlagsspannungs-Messungen nach den schnellen thermischen Behandlungen durchgeführt werden, um ein Verhältnis zwischen der Ziehgeschwindigkeit und den Wärmebehandlungs-Temperaturen zu erhalten, und ein Ergebnis der Oxid-dielektrischen Durchschlagsspannungs-Messungen im Voraus, Bedingungen einer Ziehgeschwindigkeit, wenn der Silizium-Einkristall-Ingot wachsen gelassen wird und eine Wärmebehandlungs-Temperatur in der schnellen thermischen Behandlung, basierend auf dem Verhältnis bestimmt werden, so dass eine gesamte Fläche davon in einer radialen Richtung ein N-Bereich werden kann, der nach der schnellen thermischen Behandlung angrenzend zu OSF-Bereichen existiert, und das Ziehen des Silizium-Einkristall-Ingots und die schnelle thermische Behandlung durchgeführt werden, um dadurch den Silizium-Einkristall-Wafer herzustellen.

2. Verfahren für die Herstellung des Silizium-Einkristall-Wafers nach Anspruch 1, wobei der Silizium-Einkristall-Ingot bei einer solchen Ziehgeschwindigkeit gezogen wird, dass die gesamte Fläche in der radialen Richtung ein Ni-Bereich wird.

3. Verfahren für die Herstellung des Silizium-Einkristall-Wafers nach Anspruch 1 oder Anspruch 2, wobei der Silizium-Einkristall mit Stickstoff, in einer Kon-

zentration von $1 \times 10^{11}$ - $1 \times 10^{15}$ Atomen/cm$^3$ und/oder Kohlenstoff in einer Konzentration von $1 \times 10^{16}$ - $1 \times 10^{17}$ Atomen/cm$^3$, während des Ziehens des Silizium-Einkristall-Ingots dotiert wird.

4. Verfahren für die Herstellung des Silizium-Einkristall-Wafers nach einem beliebigen von Anspruch 1 bis Anspruch 3, wobei der Silizium-Einkristall mit Sauerstoff, in einer Konzentration von nicht weniger als 8 ppm und nicht mehr als 15 ppm, während des Ziehens des Silizium-Einkristall-Ingots dotiert wird.

5. Verfahren für die Herstellung des Silizium-Einkristall-Wafers nach einem beliebigen von Anspruch 1 bis Anspruch 4, wobei die schnelle thermische Behandlung in einer nicht-oxidierenden Atmosphäre durchgeführt wird.

6. Verfahren für die Herstellung des Silizium-Einkristall-Wafers nach einem beliebigen von Anspruch 1 bis Anspruch 5, wobei in der schnellen thermischen Behandlung die Wärmebehandlungs-Temperatur auf nicht weniger als 1100°C und nicht mehr als 1300°C eingestellt wird.

**Revendications**

1. Procédé de fabrication d'une tranche de monocristal de silicium dans lequel un lingot de monocristal de silicium est tiré par un procédé de Czochralski, et une tranche découpée à partir du lingot de monocristal de silicium est soumise à un recuit thermique rapide, dans lequel les tranches découpées à partir du lingot de monocristal de silicium qui a été tiré tout en changeant une vitesse de traction sont soumises à des recuits thermiques rapides à différentes températures de traitement thermique, des mesures de tension de claquage de diélectrique d'oxyde sont effectuées après les recuits thermiques rapides afin d'obtenir une relation entre la vitesse de tirage et les températures de traitement thermique, et un résultat des mesures de tension de claquage de diélectrique d'oxyde à l'avance, les conditions d'une vitesse de tirage lorsque le lingot de monocristal de silicium est développé et une température de traitement thermique dans le recuit thermique rapide sont déterminés sur la base de la relation de sorte qu'une surface entière de celles-ci dans une direction radiale peut devenir une région N qui existe au voisinage d'une région OSF après le recuit thermique rapide, et le tirage du lingot de monocristal de silicium et le recuit thermique rapide sont effectués pour fabriquer ainsi la tranche de monocristal de silicium.

2. Procédé de fabrication de la tranche de monocristal de silicium selon la revendication 1, dans lequel le lingot de monocristal de silicium est tiré à une vitesse de tirage telle que la surface entière dans la direction radiale est une région Ni.

3. Procédé de fabrication de la tranche de monocristal de silicium selon la revendication 1 ou la revendication 2, dans lequel le monocristal de silicium est dopé avec de l'azote à une concentration de $1\times10^{11}$ à $1\times10^{15}$ atomes/cm$^3$ et/ou du carbone à une concentration de $1\times10^{16}$ à $1\times10^{17}$ atomes/cm$^3$ pendant le tirage du lingot de monocristal de silicium.

4. Procédé de fabrication de la tranche de monocristal de silicium selon l'une quelconque de la revendication 1 à la revendication 3, dans lequel le monocristal de silicium est dopé avec de l'oxygène à une concentration de pas moins de 8 ppm et pas plus de 15 ppm pendant le tirage du lingot de monocristal de silicium.

5. Procédé de fabrication de la tranche de monocristal de silicium selon l'une quelconque de la revendication 1 à la revendication 4, dans lequel le recuit thermique rapide est effectué sous une atmosphère non oxydante.

6. Procédé de fabrication de la tranche de monocristal de silicium selon l'une quelconque de la revendication 1 à la revendication 5, dans lequel, dans le recuit thermique rapide, la température de traitement thermique est fixée à pas moins de 1 100 °C et pas plus de 1 300 °C.

FIG.1

FIG.2

(a)    (b)    (c)

FIG.3

FIG.4

BMD DENSITY

FRONT SURFACE

BACK SURFACE

FIG.5

BMD DENSITY

FRONT SURFACE

BACK SURFACE

FIG.6

FIG.7

FIG.8

RTA TEMPERATUR (°C)

1280
1260
1240
1220
1200
1180
1160

0.54   0.55   0.56   0.57   0.58   0.59

PULLING RATE (mm/min)

FIG.9

Nv REGION

Ni REGION

TDDB FAILURE POSITION

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1179889 B
- JP 3085146 B
- EP 1170405 A1
- JP 2001203210 A
- US 5401669 A
- WO 2001503009 A